# EUROPÄISCHE PATENTANMELDUNG

(11) **EP 3 422 531 A1**
(43) Veröffentlichungstag der Anmeldung: **02.01.2019**
(21) Anmeldenummer: 17177934.1
(22) Anmeldetag: 26.06.2017
(51) Int. Cl.: H02J 9/06, H02J 7/00, G01R 31/36

(54) **VERFAHREN ZUR STEUERUNG EINES UNTERBRECHUNGSFREIEN STROMVERSORGUNGSSYSTEMS SOWIE ZUGEHÖRIGES STROMVERSORGUNGSSYSTEM**

(71) Anmelder: Siemens Aktiengesellschaft, 80333 München (DE)
(72) Erfinder: Paul, Wolfgang, 2344 Maria Enzersdorf (AT)
(74) Vertreter: Maier, Daniel Oliver

(57) **Zusammenfassung**

Die Erfindung betrifft ein Verfahren zur Steuerung eines unterbrechungsfreien Stromversorgungssystems sowie ein zugehöriges, unterbrechungsfreies Stromversorgungssystem zur Durchführung des erfindungsgemäßen Verfahrens. Dabei umfasst das unterbrechungsfreie Stromversorgungssystem mindestens eine Grundeinheit (GE) sowie zumindest ein Akkumulatormodul (A1, A2, A3) mit einer Überwachungseinheit (UE1, UE2, UE3). Die Grundeinheit (GE) weist dabei zumindest eine Ladeeinheit (LE) sowie eine Steuereinheit (SE) zum Ansteuern der Ladeeinheit (LE) auf und kann vom zumindest einen Akkumulatormodul (A1, A2, A3) räumlich getrennt angebracht werden. Von der Überwachungseinheit (UE1, UE2, UE3) des zumindest einen Akkumulatormoduls (A1, A2, A3) wird regelmäßig während eine Lade- und/oder Entladevorgangs ein jeweils aktueller, ladespezifischer Zustand des zumindest einen Akkumulatormoduls (A1, A2, A3) ermittelt und an die Grundeinheit (GE) übertragen. In der Grundeinheit (GE) wird der aktuell übertragene, ladespezifische Zustand des zumindest einen Akkumulatormoduls (A1, A2, A3) von der Steuereinheit (SE) ausgewertet und die Ladeeinheit (SE) der Grundeinheit (GE) entsprechend angesteuert. Dadurch wird die zwischen der Grundeinheit (GE) und dem zumindest einen Akkumulatormodul (A1, A2, A3) der unterbrechungsfreien Stromversorgungseinheit übertragene Datenmenge erheblich reduziert und die Übertragungssicherheit gesteigert.

## Beschreibung

### Technisches Gebiet

Die vorliegende Erfindung betrifft allgemein unterbrechungsfreie Stromversorgungssysteme oder so genannte Uninterruptable Power Supply- bzw. UPS-Systeme. Im Speziellen bezieht sich die vorliegende Erfindung auf ein Verfahren zur Steuerung eines unterbrechungsfreien Stromversorgungssystems sowie auf ein zugehöriges, unterbrechungsfreies Stromversorgungssystem zur Durchführung des erfindungsgemäßen Verfahrens. Dabei umfasst das unterbrechungsfreie Stromversorgungssystem mindestens eine Grundeinheit sowie zumindest ein Akkumulatormodul mit einer Überwachungseinheit. Die Grundeinheit weist dabei zumindest eine Ladeeinheit sowie eine Steuereinheit zum Ansteuern der Ladeeinheit auf und kann vom zumindest einen Akkumulatormodul räumlich getrennt angebracht werden.

### Stand der Technik

Bei vielen elektrischen Anlagen werden heutzutage häufig Stromversorgungen installiert, welche aus einem dreiphasigen Energieversorgungsnetz, insbesondere einem Drehstromnetz, gespeist werden, und eine Gleichstrom-Ausgangsspannung (z.B. 24 Volt Gleichspannung) zur Versorgung der elektrischen Anlage liefern. Um einen Betrieb der elektrischen Anlage unabhängig von Störungen und/oder Ausfällen im Energieversorgungsnetz sicherzustellen, werden üblicherweise unterbrechungsfreie Stromversorgungssysteme (kurz: USV) oder so genannte Uninterruptable Power Supply- bzw. UPS-Systeme eingesetzt. Die unterbrechungsfreie Stromversorgung dient dazu, bei einer Störung oder einem Ausfall der normalen Energieversorgung eine hilfsweise Energieversorgung für die elektrische Anlage bereitzustellen.

Ein unterbrechungsfreies Stromversorgungssystem besteht typischer Weise aus einer Grundeinheit und einem oder mehreren Akkumulatormodulen, welches zur Energiespeicherung üblicherweise einen Akkumulator umfasst. Ein Akkumulator ist ein wiederaufladbarer Speicher für elektrische Energie, typischerweise auf Basis eines elektrochemischen Systems, durch welches beim Aufladen elektrische Energie in chemische (Speicher-)Energie umgewandelt und beim Entladen wieder in elektrische Energie zurückgewandelt wird. Akkumulatortypen werden üblicherweise nach den jeweils verwendeten Materialien bezeichnet. Bekannte Akkumulatortypen sind beispielsweise Lithium-Ionen-Akkumulatoren, Blei-Akkumulatoren, etc. Synonym kann für den Begriff Akkumulator oder kurz Akku auch der Begriff wiederaufladbare Batterie bzw. Batterie verwendet werden.

Das Akkumulatormodul kann weiterhin eine Überwachungseinheit umfassen - wie beispielsweise aus der Schrift DE 198 34 740 A1 bekannt. Diese Überwachungseinheit kann einer Überwachung des Akkus dienen und kann Betriebsparameter des Akkumulators (z.B. Akku-Temperatur, Akku-Spannung, etc.) sowie charakteristische Akkumulatorparameter (z.B. Ladeschlussspannung, maximaler Ladestrom, Temperatorabhängigkeit der Ladeschlussspannung, Entladeschlussspannung, Akkumulatortyp, Akkumulatorgröße, etc.) feststellen und speichern.

Die Grundeinheit der unterbrechungsfreien Stromversorgung, welche einerseits eingangsseitig mit der Stromversorgung und ausgangsseitig mit einer zu versorgenden Last verbunden ist, umfasst zumindest eine Ladeeinheit bzw. einen Laderegler sowie eine Steuereinheit. Die Ladeeinheit bzw. der Laderegler wird zum Laden des Akkumulatormoduls bzw. der Akkumulatormodule sowie zur Umsetzung eines Lade- bzw. Entladevorgangs eingesetzt. Die Steuereinheit dient der Ansteuerung der Ladeeinheit bzw. des Ladereglers. Weiterhin weist die Grundeinheit eine Zuschalteinheit auf, durch welche bei einer Störung oder bei Ausfall des Energieversorgungsnetzes das zumindest eine Akkumulatormodul mit der Last verbunden werden kann.

Bei einer industriellen Anwendung von unterbrechungsfreien Stromversorgungssystemen können die Grundeinheit und das Akku-Modul bzw. die Akku-Module räumlich getrennt voneinander installiert werden. Die Grundeinheit mit Ladeeinheit, Steuereinheit und Zuschalteinheit befindet sich beispielsweise in einem Gehäuse, welches z.B. in einem Schaltschrank auf einer Hutschiene montiert wird. Das zugehörige Akkumulatormodul bzw. die zugehörigen Akkumulatormodule können z.B. wegen des niedrigeren Temperaturniveaus am Boden des Schaltschranks oder einer anderen Stelle angebracht sein.

Ohne Störungen bei der Energieversorgung wird von der unterbrechungsfreien Stromversorgung elektrische Energie sowohl an die angeschlossene Last als auch an das zumindest eine zugehörige Akkumulatormodul weitergeleitet - d.h. der Akku wird aufgeladen. Wenn eine Störung in der Energieversorgung auftritt, wird das zumindest eine Akkumulatormodul der unterbrechungsfreien Stromversorgung mit der Last verbunden und beginnt sich zur Last hin zu entladen, um die elektrische Energieversorgung aufrecht zu erhalten. Wenn das Energieversorgungsnetz wieder in seinen Normalzustand zurückkehrt, werden wiederrum die Last und das zumindest eine Akkumulatormodul mit elektrischer Energie versorgt. D.h. bei einer unterbrechungsfreien Stromversorgung wird während des Normalbetriebs des Energieversorgungsnetzes der zumindest eine Akku geladen und im Störfall entladen.

Beim Laden von Akkus können unterschiedliche Ladeverfahren eingesetzt werden, welche unterschiedliche Strategien zur Steuerung von Strom und Spannung beim Laden der Akkus einsetzen. Dabei hat das verwendete Ladeverfahren einen erheblichen Einfluss auf die Leistungsfähigkeit und die Lebensdauer des jeweiligen Akkus. Häufig kommt beim Laden von heutzutage häufig gebräuchlichen Akkus (z.B. Bleiakkumulator, Lithium-Ionen-Akkumulator, etc.) das so genannte IU-Ladeverfahren oder Constant Current Constant Voltage-Verfahren (CCCV-Verfahren) zum Einsatz, welches das sogenannte Konstantstrommit dem Konstantspannungs-Ladeverfahren verbindet. Dabei wird in einer ersten Phase des Ladevorgangs der Akku mit einem konstanten Strom geladen. Dabei steigt die Spannung an den Akkuklemmen mit zunehmendem Ladezustand an. Bei Erreichen der so genannten Ladeschlussspannung (End of charge voltage) am Akku wird durch die Grundeinheit von Strom- auf Spannungsregelung bzw. umgeschaltet. In der zweiten Ladephase wird dann mit konstanter Spannung weiter geladen, wobei die Spannung an den Akkuklemmen auf einem konstanten Wert gehalten wird. Mit zunehmendem Ladestand des Akkumulators sinkt der Ladestrom selbsttätig kontinuierlich ab, bis ein vorgegebener Minimalwert erreicht ist, welcher als Kriterium für eine Beendung des Ladevorgangs z.B. durch die Grundeinheit herangezogen werden kann.

Beim Ladevorgang muss allerdings berücksichtigt werden, dass eine Höhe der Ladeschlussspannung - insbesondere z.B. bei Bleiakkumulatoren - von einer Temperatur des Akkumulators abhängig ist. Bei der Ladeschlussspannung - einem Kennwert des jeweiligen Akkus - handelt es sich um eine Spannung, welche beim Ladevorgang als Klemmenspannung an den Akkuklemmen ansteht. Aufgrund der Temperaturabhängigkeit der Ladeschlussspannung muss der Wert der Ladeschlussspannung (= Umschaltpunkt im CCCV-Verfahren) der Akkutemperatur nachgeführt werden, um einen optimalen Ladezustand zu erreichen und gleichzeitig die Lebensdauer des jeweiligen Akkus nicht durch Überladen zu beeinträchtigen. D.h. eine niedrigere Akkutemperatur erfordert eine höhere Ladeschlussspannung, während eine hohe Akkutemperatur eine niedrigere Ladeschlussspannung bedingt.

Analog ist bei einem Entladevorgang eines Akkus zu beachten, dass eine Tiefentladung - d.h. eine Stromentnahme bis zur nahezu vollständigen Erschöpfung der Kapazität des Akkumulators - vermieden wird, um einen Schädigung des Akkumulators zu verhindern. D.h. der Entladevorgang sollte bei Erreichen oder Unterschreiten einer so genannten Entladeschlussspannung - ein weiterer Kennwert des jeweiligen Akkus - durch die Grundeinheit beendet werden. Die Entladeschlussspannung ist eine festgesetzte Spannung, bis zu welcher der Akku entladen werden darf und hängt vom jeweiligen Akkutyp ab.

Die Grundeinheit, in welcher Steuereinheit und Ladeeinheit zum Steuerung und Regeln des Lade- und auch Entladevorgangs angebracht sind, ist häufig räumlich getrennt vom Akkumulator bzw. den Akkumulatoren des unterbrechungsfreien Stromversorgungssystems angebracht. Um eine temperaturabhängige Nachführung der für den eingesetzten Akku spezifischen Ladeschlussspannung während des Ladevorgangs zu gewährleisten, müssen entsprechende Daten (z.B. Akkuparameter, aktuelle Werte von Betriebsparametern wie Temperatur, Spannung, etc.) zwischen der Grundeinheit bzw. der zugehörigen Steuereinheit und dem zumindest einen Akkumulatormodul des unterbrechungsfreien Stromversorgungssystem bzw. einer im Akkumulatormodul integrierten Überwachungseinheit übertragen werden. In analoger Weise müssen beim Entladevorgang ebenfalls entsprechende Daten (z.B. aktuelle Werte von Betriebsparametern wie z.B. Akkuspannung, etc.) zwischen der Grundeinheit bzw. der zugehörigen Steuereinheit und dem zumindest einen Akkumulatormodul bzw. der zugehörigen Überwachungseinheit übertragen werden, um ein Tiefladen des Akkus bzw. der Akkus zu verhindern.

Aus der Schrift DE 10 2010 048 188 A1 ist eine Akkumulator-Kontrollvorrichtung sowie ein zugehöriges Verfahren für elektrische Hilfsversorgungen bekannt, bei welchen für eine Steuerung des Lade- und/oder Entladevorgangs aktuelle Messwerte von Betriebsparametern - insbesondere Akkutemperatur und Akkuspannung - aus dem Akkumulator an eine Hilfsversorgungsvorrichtung übertragen werden. Dem Akkumulator ist dazu eine Akkumulator-Kontrollvorrichtung vorgeschaltet, welche die für einen optimalen Lade- bzw. Entladevorgang erforderlichen Parameterwerte (z.B. Akkutemperatur, Akkuspannung, Grundwert der Ladeschluss- bzw. Entladeschlussspannung, Temperaturcharakteristik des Akkus, etc.) vom Akkumulator über einen Bus an die Hilfsversorgungsvorrichtung übermittelt. Die Akkumulator-Kontrollvorrichtung weist dazu einen Mikrocontroller auf, welcher das Messen, Auswerten und Übertragen dieser Parameterwerte steuert. Werden mehrere Akkus an die Grundeinheit angeschlossen, so werden diese über einen Klemmenblock zusammengeschaltet, wobei für das Übertragen der Daten des jeweiligen Akkus jedem Akku eine eigene eindeutige Kommunikationsadresse zugewiesen wird.

Dabei erweist es sich als nachteilig, dass eine relativ große Datenmenge (wie z.B. aktuelle Messwerte, erforderliche Parameter für einen optimalen Lade- bzw. Entladevorgang, etc.) zwischen der jeweiligen Akkumulator-Kontrollvorrichtung und der Hilfsversorgungsvorrichtung für die Steuerung des jeweiligen Lade- bzw. Entladevorgangs übertragen werden. Die Datenmenge muss dann von der Hilfsversorgungsvorrichtung - vor allem bei Einsatz mehrere Akkumulatoren - mit relativ großem Aufwand für die Steuerung des Lade- bzw. Entladevorgangs ausgewertet werden. Neben Fehlern bei der Übertragung der Datenmenge über den Bus, der die Akkumulator-Kontrollvorrichtung mit der Hilfsversorgungsvorrichtung verbindet, kann es auch bei der Auswertung der relativ großen Datenmenge in der Hilfsversorgungsvorrichtung zu Fehlern und damit zu Fehlsteuerung beim Laden und/oder Entladen des jeweiligen Akkus kommen.

### Darstellung der Erfindung

Der Erfindung liegt daher die Aufgabe zugrunde, ein Verfahren zur Steuerung eines unterbrechungsfreien Stromversorgungssystems sowie ein zugehöriges, unterbrechungsfreies Stromversorgungssystem anzugeben, durch welche eine Steuerung eines Lade- und/oder Entladevorgangs von im unterbrechungsfreien Stromversorgungssystem eingesetzten Akkumulatoren - insbesondere bei räumlicher Trennung von einer Grundeinheit - auf einfache Weise verbessert und eine Fehlerwahrscheinlichkeit reduziert werden kann.

Diese Aufgabe wird durch ein Verfahren der eingangs genannten Art sowie ein zugehöriges unterbrechungsfreies Stromversorgungssystem mit den Merkmalen gemäß den unabhängigen Patentansprüchen gelöst. Vorteilhafte Ausführungsformen der vorliegenden Erfindung sind in den abhängigen Ansprüchen beschrieben.

Erfindungsgemäß erfolgt die Lösung der Aufgabe durch ein Verfahren zur Steuerung eines unterbrechungsfreien Stromversorgungssystems der eingangs erwähnten Art, wobei beim Verfahren während eines Ladevorgangs und/oder während eines Entladevorgangs eines zumindest einen Akkumulatormoduls regelmäßig von einer Überwachungseinheit des zumindest einen Akkumulatormoduls ein jeweils aktueller, ladespezifischer Zustand des zumindest einen Akkumulatormoduls ermittelt wird. Der jeweils aktuelle, ladespezifische Zustand des zumindest einen Akkumulatormoduls wird an die Grundeinheit des unterbrechungsfreien Stromversorgungssystems übertragen. Dort wird der jeweils aktuell übertragene, ladespezifische Zustand von der Steuereinheit der Grundeinheit ausgewertet und die Ladeeinheit der Grundeinheit entsprechend angesteuert.

Der Hauptaspekt des erfindungsgemäßen Verfahrens besteht darin, dass dadurch ein Lade- und Entladevorgänge von einem oder mehreren Akkumulatormodulen in einem unterbrechungsfreien Stromversorgungssystems auf einfache Weise gesteuert und Fehlsteuerungen, welche gegebenenfalls zu Schädigungen des/der Akkumulatormodule führen können, reduziert werden können. Durch das erfindungsgemäße Verfahren werden zwischen der Überwachungseinheit des zumindest einen Akkumulatormoduls und der Grundeinheit bzw. zugehörigen Steuereinheit nur die jeweils aktuellen, ladespezifischen Zustände des zumindest eine Akkumulatormoduls - beispielsweise in Form von digitalen Zustandssignalen - übertragen. Eine Übertragung von aktuellen Messwerten von Akkumulatorparametern wie z.B. Temperatur, Spannung, etc. kann dabei entfallen, wodurch die Fehleranfälligkeit erheblich reduziert werden kann. D.h. die gegenständliche Erfindung weist eine wesentlich geringere zu übertragende Datenmenge durch eine Reduktion der Kommunikation zwischen dem zumindest einen Akkumulatormodul bzw. zugehöriger Überwachungseinheit und der Grundeinheit des Stromversorgungssystems, insbesondere der Steuereinheit, auf beispielsweise digitale Zustandssignale auf, wodurch eine Übertragungssicherheit wesentlich gesteigert wird.

Vor allem beim Einsatz von mehreren Akkumulatormodulen im unterbrechungsfreien Stromversorgungssystem wird die Handhabung der Daten insbesondere in der Steuereinheit der Grundeinheit wesentlich einfacher. Von der Überwachungseinheit wird beispielsweise für jedes Akkumulatormodul ein jeweils aktueller, ladespezifischer Zustand ermittelt und an die Steuereinheit in der Grundeinheit übertragen. Dort können die jeweils aktuellen, ladespezifischen Zustände der Akkumulatormodule z.B. logisch verknüpft werden und im einfachsten Fall die Ladeeinheit von der Steuereinheit so angesteuert werden, dass z.B. bei Erreichen der Ladeschlussspannung eines ersten Akkumulators bzw. bei Erreichen der Entladeschlussspannung eines ersten Akkumulators der Ladevorgang bzw. der Entladevorgang (oder das Puffern) beendet wird. Dadurch wird auf sehr einfache Weise ein Belastung und/oder Schädigung der verwendeten Akkumulatoren z.B. durch Überladung bzw. Tiefentladung verhindert.

Idealerweise wird der jeweils aktuelle, ladespezifische Zustand des zumindest einen Akkumulatormoduls von der Überwachungseinheit anhand von aktuellen Messwerten von Betriebsparametern des zumindest einen Akkumulatormoduls sowie anhand von vorgegebenen Akkumulatorparametern für das zumindest eine Akkumulatormodul bestimmt werden. Für die Ermittlung des aktuellen, ladespezifischen Zustands werden von der Überwachungseinheit als Betriebsparameter z.B. eine aktuelle Temperatur und/oder eine aktuelle Klemmenspannung des zumindest einen Akkumulators gemessen. Weiterhin werden von der Überwachungseinheit vorgegebene, charakteristische Akkumulatorparameter zur Bestimmung des aktuellen, ladespezifischen Zustands herangezogen wie z.B. eine Temperaturcharakteristik der Ladeschlussspannung des jeweiligen Akkus, Typ und/oder Größe des Akkus, Ladeschlussspannung, Entladeschlussspannung, max. Höhe des Ladestroms, etc. herangezogen. Diese Akkumulatorparameter können beispielsweise zu einem Zeitpunkt des Systemhochlaufs der Überwachungseinheit zur Verfügung gestellt oder vom Bediener oder Hersteller des unterbrechungsfreien Stromversorgungssystems fest in der Überwachungseinheit gespeichert werden.

Weiterhin ist es vorteilhaft, wenn die ladespezifischen Zustände des zumindest einen Akkumulatormoduls in Abhängigkeit von zumindest einen vorgegebenen, charakteristischen Akkumulatorparameter für den Ladevorgang bzw. für den Entladevorgang definiert werden. So können beispielsweise für den Ladevorgang ladespezifische Zustände in Abhängigkeit von der Ladeschlussspannung des jeweiligen Akkus festgelegt werden. Als mögliche ladespezifische Zustände können z.B. "Ladeschlussspannung nicht erreicht", "Ladeschlussspannung erreicht" und "Ladeschlussspannung überschritten" definiert werden. In ähnlicher Weise können für den Entladevorgang des zumindest eine Akkumulatormodul ladespezifische Zustände in Abhängigkeit der Entladeschlussspannung des jeweiligen Akkus definiert werden - wie z.B. "Entladeschlussspannung nicht erreicht" und "Entladeschlussspannung erreicht".

Es ist auch günstig, wenn zusätzlich für die Grundeinheit Funktionszustände definiert werden. Durch diese Funktionszustände können auf einfache Weise der jeweilige Ladevorgang und/oder der jeweilige Entladevorgang gestartet und/oder gestoppt werden. Dazu können beispielsweise Funktionszustände wie z.B. "Laden aktiv", "Laden inaktiv", "Entladen aktiv", "Entladen inaktiv" festgelegt werden. Diese Funktionszustände können an das zumindest einen Akkumulatormodul bzw. an die zugehörige Überwachungseinheit übertragen werden.

Eine weitere, vorteilhafte Ausführungsvariante des erfindungsgemäßen Verfahrens sieht vor, dass die aktuellen Messwerte der Betriebsparameter wie z.B. Temperatur, Klemmenspannung, etc. des zumindest einen Akkumulatormoduls an die Grundeinheit des unterbrechungsfreien Stromversorgungssystems und/oder an eine Kontrolleinheit, welche dem unterbrechungsfreien Stromversorgungssystem übergeordnet ist, weitergeleitet werden. Die übertragenen Messwerte der Betriebsparameter können dann für weitere Auswertungen und/oder optische Darstellungen herangezogen werden, anhand welchen ein tiefergehende Beurteilung von beispielsweise einer Einsatzbereitschaft, Alterungsprozess, etc. des zumindest einen Akkumulatormoduls durchgeführt werden kann.

Vorteilhafter Weise werden die aktuellen, ladespezifischen Zustände des zumindest einen Akkumulatormoduls und die Funktionszustände der Grundeinheit über eine digitale Schnittstelle zwischen der Grundeinheit und dem zumindest einen Akkumulatormodul bzw. der zugehörigen Überwachungseinheit übertragen. Die zu übertragende Datenmenge bzw. die Kommunikation zwischen Grundeinheit und dem zumindest einen Akkumulatormodul wird damit auf eine Übertragung von rein digitalen Zustandssignalen reduziert. Dadurch wird die Übertragungssicherheit gesteigert. Insbesondere beim Einsatz von mehreren Akkumulatormodulen werden die zu übertragene Datenmenge und das Datenhandling durch den Einsatz von digitalen Zustandssignalen und eine digitale Schnittstelle erheblich vereinfacht werden.

Weiterhin können in einfacher Weise auch die aktuellen Messwerte der Betriebsparameter (z.B. Temperatur, Klemmenspannung, etc.) über die digitale Schnittstelle von der Überwachungseinheit an die Grundeinheit übertragen werden. Dabei werden die von der Überwachungseinheit des zumindest einen Akkumulatormoduls gemessenen Betriebsparameter, insbesondere Temperatur und/oder Klemmenspannung digitalisiert und als digitale Werte übertragen. Diese können relativ einfach in der Grundeinheit oder eine übergeordneten Kontrolleinheit ausgewertet bzw. optisch dargestellt werden.

Zusätzlich kann zur digitalen Schnittstelle eine analoge Schnittstelle zwischen Grundeinheit und dem zumindest einen Akkumulatormodul bzw. der zugehörigen Überwachungseinheit implementiert werden. Über diese analoge Schnittstelle können die aktuellen Messwerte der Betriebsparameter - alternativ oder zusätzlich - von der Überwachungseinheit an die Grundeinheit, insbesondere die Steuereinheit, übertragen werden. Dazu werden die aktuellen Messwerte der Betriebsparameter, insbesondere der Akkutemperatur und/oder der Klemmenspannung, von der Überwachungseinheit des zumindest einen Akkumulatormoduls als analoge Spannungswerte abwechselnd an die analoge Schnittstelle angelegt. In der Grundeinheit können die über die analoge Schnittstelle übertragenen Spannungswerte z.B. mittels eines Analog-Digital-Konverters digitalisiert werden. Weiterhin wird der Grundeinheit über die digitale Schnittstelle für eine korrekte Interpretation mitgeteilt, welcher Betriebsparameter gerade über die analoge Schnittstelle als analoger Spannungswert übertragen wird.

Weiterhin wird die Aufgabe durch ein unterbrechungsfreies Stromversorgungssystem zur Durchführung des erfindungsgemäßen Verfahrens gelöst. Dieses unterbrechungsfreie Stromversorgungssystem besteht zumindest aus einer Grundeinheit und zumindest einem Akkumulatormodul. Die Grundeinheit umfasst dabei zumindest einen Ladeeinheit sowie eine Steuereinheit, durch welche die Ladeeinheit vor allem zum Regeln von Lade- und Entladevorgängen angesteuert wird. Das zumindest eine Akkumulatormodul weist eine Überwachungseinheit auf und kann räumlich getrennt von der Grundeinheit angebracht sein. Weiterhin ist die Überwachungseinheit des zumindest einen Akkumulatormoduls dazu eingerichtet, regelmäßig eine jeweils aktuellen, ladespezifischen Zustand des zumindest einen Akkumulatormoduls zu ermitteln und an die Grundeinheit zu übertragen. Die Steuereinheit der Grundeinheit ist dazu eingerichtet, den jeweils aktuell übertragenen, ladespezifischen Zustand des zumindest einen Akkumulatormoduls auszuwerten und die Ladeeinheit entsprechend anzusteuern.

Der Hauptaspekt des erfindungsgemäßen, unterbrechungsfreien Stromversorgungssystems besteht ebenfalls darin, eine zwischen Grundeinheit und Akkumulatormodul bzw. der zugehörigen Überwachungseinheit zu übertragenden Datenmenge zu reduzieren und die Übertragungssicherheit zu erhöhen. Es werden beim erfindungsgemäßen, unterbrechungsfreien Stromversorgungssystem für einen Lade- und/oder Entladevorgang des zumindest einen Akkumulatormoduls nur die jeweils aktuellen Zustände für die Steuerung und Regelung an die Grundeinheit übertragen. Eine Übertragung von aktuellen Messwerten der Betriebsparameter (z.B. Akkutemperatur, Klemmenspannung, etc.) ist daher nicht notwendig.

Um die entsprechenden aktuellen, ladespezifischen Zustände ableiten zu können, ist die Überwachungseinheit des zumindest einen Akkumulatormoduls idealerweise dazu eingerichtet, aktuelle Werte von Betriebsparametern, insbesondere der Akkutemperatur und/oder der Klemmenspannung, zu messen. Dazu kann die Überwachungseinheit beispielsweise entsprechende Sensoren aufweisen. Aus den aktuellen, gemessenen Werten der Betriebsparameter sowie anhand von vorgegebenen Akkumulatorparameter (z.B. Ladeschlussspannung, maximaler Ladestrom, Temperatorabhängigkeit der Ladeschlussspannung, Entladeschlussspannung, Akkumulatortyp, Akkumulatorgröße, etc.), welche z.B. in der Überwachungseinheit hinterlegt sind, kann dann ein aktueller, ladespezifischer Zustand wie z.B. "Ladeschlussspannung nicht erreicht", "Ladeschlussspannung erreicht", "Ladeschlussspannung überschritten", "Entladeschlussspannung nicht erreicht", "Entladeschlussspannung erreicht" für Ladevorgang bzw. Entladevorgang ermittelt werden und die Grundeinheit übertragen werden.

Für die Übertragung der aktuellen, ladespezifischen Zustände an die Grundeinheit ist weiterhin vorteilhafter Weise eine digitale Schnittstelle vorgesehen. Die digitale Schnittstelle ist weiterhin für eine Übertragung von Funktionszuständen (z.B. "Laden aktiv", "Laden inaktiv", "Entladen aktiv", "Entladen inaktiv") einsetzbar, welche für die Grundeinheit definierbar sind. Mittels der Übertragung dieser Funktionszustände der Grundeinheit an die Überwachungseinheit des zumindest einen Akkumulatormoduls kann auf einfache Weise ein Lade- und/oder Entladevorgang gestartet und/oder gestoppt werden.

Zusätzlich kann die digitale Schnittstelle für eine Übertragung von aktuellen Messwerten der Betriebsparameter des zumindest einen Akkumulatormoduls nutzbar sein. Die Messwerte sind damit für die Grundeinheit des unterbrechungsfreien Stromversorgungssystems und/oder für eine übergeordnete Kontrolleinheit für tiefergreifende Auswertungen und/oder optische Darstellung, insbesondere betreffend die Akku-Funktionalität, nutzbar.

Zusätzlich zur digitalen Schnittstelle kann auch eine analoge Schnittstelle beim erfindungsgemäßen, unterbrechungsfreien Stromversorgungssystem vorgesehen sein. Über die analoge Schnittstelle können alternativ oder zusätzliche die aktuellen Messwerte der Betriebsparameter des zumindest einen Akkumulatormoduls z.B. in Form von Spannungswerten an die Grundeinheit übertragen werden.

### Kurzbeschreibung der Zeichnung

Die Erfindung wird nachfolgend in beispielhafter Weise anhand der beigefügten Figuren erläutert. Dabei zeigen:
- Figur 1: schematisch einen beispielhaften Ablauf des erfindungsgemäßen Verfahrens zur Steuerung eines erfindungsgemäßen, unterbrechungsfreien Stromversorgungssystems
- Figur 2: schematisch und beispielhaft die erfindungsgemäße, unterbrechungsfreie Stromversorgungssystem mit mehreren Akkumulatormodulen

### Ausführung der Erfindung

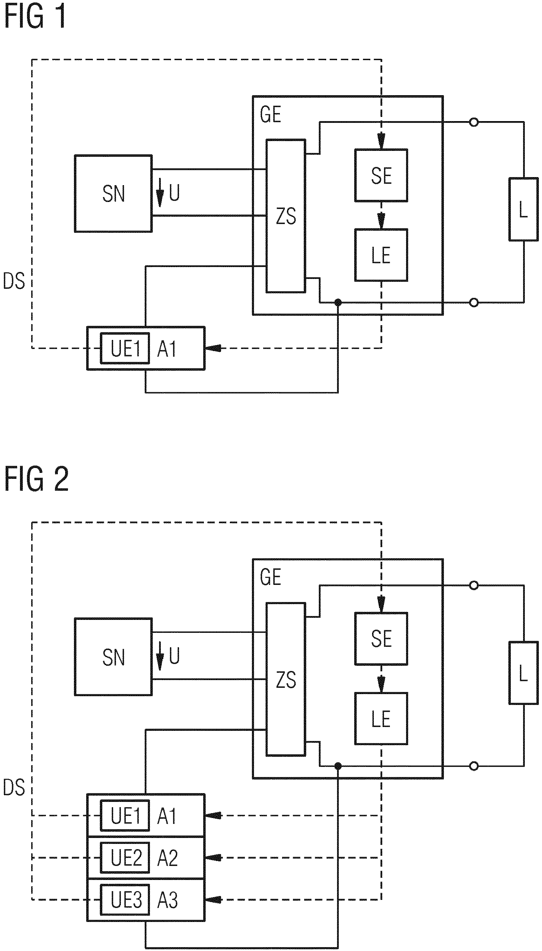

Figur 1 zeigt in schematischer und beispielhafter Weise ein erfindungsgemäßes, unterbrechungsfreies Stromversorgungssystem, durch welche bei einem Ausfall oder einer Störung eines versorgenden Stromnetzes, insbesondere Drehstromnetz, eine Versorgung einer Last L (z.B. elektrischen Anlage) aufrecht erhalten werden kann. Das unterbrechungsfreie Stromversorgungssystem ist über ein Schaltnetzteil SN mit dem Versorgungsnetz - üblicherweise einem Drehstromnetz - verbunden. Vom Schaltnetzteil SN wird eine mehrphasige Wechselspannung (meist eine 3-phasige Wechselspannung) in einen Gleichspannung U (z.B. 24 V) am Ausgang des Schaltnetzteils SN umgewandelt.

Das unterbrechungsfreie Stromversorgungssystem weist zumindest eine Grundeinheit GE sowie zumindest ein Akkumulatormodul A1 auf, wobei das Akkumulatormodul A1 räumlich getrennt von der Grundeinheit GE angebracht ist, aber über Leitungen mit der Grundeinheit GE verbunden ist.

Die Grundeinheit GE umfasst zumindest eine Steuereinheit SE und eine Ladeeinheit LE. Die Steuereinheit SE kann beispielsweise als Mikrocontroller ausgeführt sein und dient der Ansteuerung der Ladeeinheit LE. Über die Ladeeinheit LE werden Lade- und/oder Entladevorgänge des zumindest einen Akkumulatormoduls A1 geregelt- d.h. die Ladeeinheit LE sorgt dafür, dass ein Ladestrom und/oder eine Ladespannung bzw. ein Entladestrom und/oder eine Entladespannung innerhalb vorgegebener Grenzen bleibt. Die Grenzen für Strom und Spannung wie z.B. eine Höhe des Ladestroms (z.B. maximaler/minimaler Ladestrom), zulässige Entladeschlussspannung, etc. können beispielsweise zum Zeitpunkt des Hochlaufen des Stromversorgungssystems vom zumindest einen Akkumulatormodul A1 an die Grundeinheit GE übertragen werden oder z.B. bei Installation oder Inbetriebnahme vom Betreiber fest eingestellt werden.

Weiterhin weist die Grundeinheit GE eine Zuschalteinheit ZS auf. Durch die Zuschalteinheit ZS wird bei einem Ausfall oder einer Störung des Versorgungsnetzes auf eine Versorgung der Last L mit der Gleichspannung U durch das zumindest eine Akkumulatormodul A1 umgeschaltet.

Das zumindest eine Akkumulatormodul A1 weist eine Überwachungseinheit UE1 auf. Als Überwachungseinheit UE1 kann beispielsweise ein kleiner Mikrocontroller eingesetzt werden. Die Überwachungseinheit UE1 ist dazu eingerichtet, aktuelle Werte von Betriebsparameter wie z.B. Temperatur, Klemmenspannung, etc. des zugehörigen Akkumulator A1 zu messen. Dazu kann die Überwachungseinheit UE1 beispielsweise entsprechende Sensoren aufweisen. Weiterhin sind in der Überwachungseinheit UE1 Akkumulatorparameter (z.B. Ladeschlussspannung, maximaler Ladestrom, Temperatorabhängigkeit der Ladeschlussspannung, Entladeschlussspannung, Akkumulatortyp, Akkumulatorgröße, etc.) für den zugehörige Akkumulator A1 hinterlegt.

Weiterhin ist eine digitale Schnittstelle DS vorgesehen, über welche Daten zwischen der Grundeinheit GE bzw. der Steuereinheit SE der Grundeinheit GE und dem zumindest einen Akkumulatormodul A1 übertragen werden. So können beispielsweise beim Hochlaufen des unterbrechungsfreien Stromversorgungssystems von der Überwachungseinheit UE1 charakteristische Akkumulatorparameter wie z.B. maximaler Ladestrom, Entladeschlussspannung, Akkumulatortyp, Akkumulatorgröße, etc. an die Steuereinheit SE der Grundeinheit GE übertragen werden. Die digitale Schnittstelle DS ist auch für einen Übertragung aktueller Messwerte der Betriebsparameter des zumindest einen Akkumulatormoduls A1 nutzbar, welche dann für weitere Auswertungen und/oder optische Darstellungen in die Grundeinheit GE oder in einer übergeordneten Kontrolleinheit verwendet werden können.

Zusätzlich zur digitalen Schnittstelle DS kann für eine Datenübertragung, insbesondere zur Übertragung von Messwerten der Betriebsparameter (z.B. Temperatur, Spannung, etc.) eine analoge Schnittstelle vorgesehen sein. Die analoge Schnittstelle ist in Figur 1 aus Gründen der Übersicht nicht dargestellt. An die analoge Schnittstelle können die aktuellen Messwerte der Betriebsparameter, insbesondere der Akkutemperatur und/oder der Klemmenspannung, von der Überwachungseinheit UE1 des zumindest einen Akkumulatormoduls A1 als analoge Spannungswerte abwechselnd angelegt. In der Grundeinheit GE können die über die analoge Schnittstelle übertragenen Spannungswerte z.B. mittels eines Analog-Digital-Konverters digitalisiert werden. Zusätzlich dazu muss der Grundeinheit GE über die digitale Schnittstelle für eine korrekte Interpretation der Messwerte mitgeteilt, welcher Betriebsparameter gerade über die analoge Schnittstelle als analoger Spannungswert übertragen wird.

Beim dem erfindungsgemäßen, unterbrechungsfreien Stromversorgungssystem werden für eine Steuerung eines Ladevorgangs wie für die Steuerung eines Entladevorgangs ladespezifische Zustände definiert. Diese ladespezifischen Zustände hängen von zumindest einem vorgegebenen Akkumulatorparameter ab. So werden beispielsweise für den Ladevorgang des Akkumulatormoduls A1 ladespezifische Zustände in Abhängigkeit der Ladeschlussspannung definiert - wie z.B. "Ladeschlussspannung nicht erreicht", "Ladeschlussspannung erreicht", "Ladeschlussspannung überschritten". Für den Entladevorgang des zumindest einen Akkumulatormoduls A1 wird z.B. die Entladeschlussspannung für die Definition der ladespezifischen Zustände herangezogen und diese beispielsweise als "Entladeschlussspannung nicht erreicht" und "Entladeschlussspannung erreicht" festgelegt. Diese ladespezifischen Zustände werden über die digitale Schnittstelle DS an die Grundeinheit GE bzw. an die zugehörige Steuereinheit SE übertragen.

Weiterhin können für die Grundeinheit GE ebenfalls Funktionszustände wie z.B. "Laden aktiv", "Laden inaktiv", "Entladen aktiv", "Entladen inaktiv" definiert werden. Die jeweiligen Funktionszustände der Grundeinheit GE werden zum Starten und/oder Stoppen des Lade- bzw. Entladevorgangs an das zumindest eine Akkumulatormodul A1 über die digitale Schnittstelle DS übertragen. Durch ein wechselweises Übertragen der Funktionszustände der Grundeinheit GE und ladespezifischen Zustände des zumindest einen Akkumulatormoduls A1 werden Lade- und/oder Entladevorgang des Akkumulatormoduls A1 gesteuert.

Ein Ladevorgang wird beispielsweise mit der Übertragung des Funktionszustands "Laden aktiv" von der Grundeinheit GE an das Akkumulatormodul A1 gestartet. Durch die Steuereinheit SE wird gleichzeitig über die Ladeeinheit LE ein vorgegebener konstanter Ladestrom eingestellt. Die Höhe des Ladestroms richtet sich nach den Akkumulatorparametern, welche z.B. beim Systemhochlauf über die digitale Schnittstelle DS vom Akkumulatormodul A1 bzw. der zugehörigen Überwachungseinheit UE1 an die Grundeinheit GE übertragen oder bei Installation bzw. Inbetriebnahme vom Betreiber des unterbrechungsfreien Stromversorgungssystems fest gestellt wurden.

Von der Überwachungseinheit UE1 des zumindest einen Akkumulatormoduls A1 werden daraufhin regelmäßig die Betriebsparameter, insbesondere Akkutemperatur und Klemmenspannung, gemessen. Anhand der aktuellen Messwerte der Betriebsparameter und auf Basis von vorgegebenen Akkumulatorparametern des zumindest einen Akkumulators A1 wird dann von der Überwachungseinheit UE1 der aktuelle, ladespezifische Zustand des zumindest einen Akkumulatormoduls A1 ermittelt. Das bedeutet, von Überwachungseinheit UE1 werden während des Ladevorgangs regelmäßig die aktuellen Wert von Akkutemperatur und Klemmenspannung mit einer temperaturabhängigen, momentan erforderlichen Ladeschlussspannung verglichen, welche auch den Akkumulatorparametern wie z.B. einer Temperaturcharakteristik der Ladeschlussspannung für den eingesetzten Akkutyp ableitbar ist. Dementsprechend wird aus den möglichen, ladespezifischen Zuständen für den Ladevorgang (z.B. "Ladeschlussspannung nicht erreicht", "Ladeschlussspannung erreicht", "Ladeschlussspannung überschritten") der aktuell gültige, ladespezifische Zustand über die digitale Schnittstelle DS an die Steuereinheit SE der Grundeinheit GE übertragen.

Bei einem aktuell übertragenen, ladespezifischen Zustand "Ladeschlussspannung nicht erreicht" wird beispielsweise die Ladeeinheit LE von der Steuereinheit SE angewiesen, mit der Konstantstromladung des Akkumulators A1 fortzufahren - d.h. den Ladestrom auf dem vorgegebenen Wert zu halten. Bei einem aktuell übertragenen, ladespezifischen Zustand "Ladeschlussspannung erreicht" wird beispielsweise die Ladeeinheit LE von der Steuereinheit SE angewiesen, von der Konstantstromladung in eine Konstantspannungsladung zu wechseln - d.h. die Spannung wird auf einem konstanten Wert gehalten. Wird hingegen z.B. der ladespezifische Zustand "Ladeschlussspannung überschritten" gemeldet, so wird mittels Steuereinheit SE und über den Ladeeinheit LE bei der Konstantspannungsladung die Ladeschlussspannung schrittweise so lange reduziert, bis von der Überwachungseinheit UE1 des zumindest einen Akkumulatormoduls A1 wieder der ladespezifische Zustand "Ladeschlussspannung erreicht" gemeldet wird oder ein minimaler Ladestrom unterschritten ist. Dann wird der Ladevorgang beendet. Beim Beenden des Ladevorgangs wird dann von der Grundeinheit GE der Funktionszustand "Laden inaktiv" über die digitale Schnittstelle DS an das zumindest eine Akkumulatormodul A1 gesendet.

Für einem Entladevorgang des Akkumulators A1 - z.B. wenn der Akkumulator A1 über die Zuschalteinheit ZS mit der Last L verbunden wird - kann analog zum Ladevorgang beispielsweise von der Grundeinheit GE der Funktionszustand "Entladen aktiv" an das zumindest eine Akkumulatormodul A1 bzw. an die zugehörige Überwachungseinheit UE1 gesendet werden. Von der Überwachungseinheit UE1 des zumindest einen Akkumulatormoduls A1 werden daraufhin regelmäßig die Betriebsparameter, insbesondere die Spannung, gemessen. Anhand der aktuellen Messwerte der Betriebsparameter und auf Basis von vorgegebenen Akkumulatorparametern des zumindest einen Akkumulators A1, insbesondere der Entladeschlussspannung des Akkumulators A1, wird dann von der Überwachungseinheit UE1 der aktuelle, ladespezifische Zustand des zumindest einen Akkumulatormoduls A1 ermittelt.

Solange von der Überwachungseinheit UE1 der ladespezifische Zustand "Entladeschlussspannung nicht erreicht" an die Steuereinheit SE übertragen wird, wird mit dem Entladevorgang fortgesetzt. Wird von der Überwachungseinheit UE1 der ladespezifische Zustand "Entladeschlussspannung erreicht" an die Steuereinheit SE gesendet, so wird von der Grundeinheit GE der Entladevorgang beendet, um ein Tiefentladen des zumindest einen Akkumulatormoduls A1 zu verhindern. Von der Grundeinheit GE kann dazu z.B. der Funktionszustand "Entladen inaktiv" über die digitale Schnittstelle DS an das zumindest einen Akkumulatormodul A1 übertragen werden, um das Entladen zu beenden.

Figur 2 zeigt wiederum schematisch und beispielhaft das erfindungsgemäße, unterbrechungsfreie Stromversorgungssystem mit zumindest der Grundeinheit GE, welche zumindest die Zuschalteinheit ZS, die Steuereinheit SE und die Ladeeinheit LE aufweist. Das unterbrechungsfreie Stromversorgungssystem weist nun allerdings mehrere - in Figur 2 drei beispielhafte, parallel geschaltete Akkumulatormodule A1, A2, A3 auf. Jedes Akkumulatormodul A1, A2, A3 hat dabei jeweils eine zugehörige Überwachungseinheit UE1, UE2, UE3 (z.B. Mikrokontroller) integriert, von welcher die aktuellen Werte der Betriebsparameter des jeweiligen Akkumulatormoduls A1, A2, A3 gemessen und anhand der jeweils hinterlegten Akkumulatorparameter die jeweils aktuellen ladespezifischen Zustände des jeweils zugehörigen Akkumulatormoduls A1, A2, A3 regelmäßig ermittelt werden können.

Die aktuell ermittelten Zustände während eines Lade- und/oder Entladevorgangs - wie z.B. "Ladeschlussspannung nicht erreicht", "Ladeschlussspannung erreicht", "Ladeschlussspannung überschritten", "Entladeschlussspannung nicht erreicht" und "Entladeschlussspannung erreicht" - für das jeweilige Akkumulatormodul A1, A2, A3 werden von der jeweils zugehörigen Überwachungseinheit UE1, UE2, UE3 über die digitale Schnittstelle DS an die Steuereinheit SE der Grundeinheit GE übertragen. Die digitale Schnittstelle DS ist beispielsweise als eine serielle Datenschnittstelle ausgeführt, welche an alle Akkumulatormodule A1, A2, A3 geführt wird bzw. welche von den Überwachungseinheiten UE1, UE2, UE3 der Akkumulatormodule A1, A2, A3 genutzt wird, um die aktuell ermittelten Zustände zu an die Grundeinheit GE zu übertragen.

In der Steuereinheit SE werden dann die von den jeweiligen Überwachungseinheiten UE1, UE2, UE3 aktuell übermittelten, ladespezifischen Zustände logisch verknüpft. Aus dieser logischen Verknüpfung wird dann eine entsprechende Ansteuerung für die Ladeeinheit LE ermittelt und der Lade- bzw. Entladevorgang der Akkumulatormodule A1, A2, A3 gesteuert. D.h. wird z.B. während des Entladevorgangs von einem der Akkumulatormodule A1, A2, A3 der ladespezifische Zustand "Entladeschlussspannung erreicht" gemeldet, so wird der Entladevorgang für die Akkumulatormodule A1, A2, A3 beendet, um ein Tiefentladen zu verhindern. Analog wird beim Ladevorgang für alle Akkumulatormodule A1, A2, A3 des unterbrechungsfreien Stromversorgungssystems die im Modus der Konstantspannungsladung die Ladespannung schrittweise auf die Ladeschlussspannung reduziert bzw. der Ladevorgang beendet, wenn von zumindest einem Akkumulatormodul A1, A2, A3 eine ladespezifischer Zustand "Ladeschlussspannung überschritten" über die digitale Schnittstelle DS an die Grundeinheit GE übertragen wird.

Die Anzahl der vom unterbrechungsfreien Stromversorgungssystem einsetzbaren Akkumulatormodule A1, A2, A3 ist von eine Anzahl an Kommunikationsadressen abhängig die von der verwendeten digitalen Schnittstelle DS bzw. vom Bus zur Datenübertragung zur Verfügung gestellt werden können. Über die jeweilige Kommunikationsadresse können die Akkumulatormodule A1, A2, A3 unterschieden werden, sodass nachvollziehbar ist, von welchem Akkumulatormodul A1, A2, A3 bzw. welcher zugehörigen Überwachungseinheit UE1, UE2, UE3 welcher ladespezifische Zustand bzw. welche Messdaten für eine Weiterverarbeitung übertragen worden sind.

## Patentansprüche

1. Verfahren zur Steuerung eines unterbrechungsfreien Stromversorgungssystems mit zumindest einer Grundeinheit (GE), welche zumindest eine Ladeeinheit (LE) und eine Steuereinheit (SSE) zum Steuern der Ladeeinheit umfasst, sowie mit zumindest einem Akkumulatormodul (A1, A2, A3), welches eine Überwachungseinheit (UE1, UE2, UE3)aufweist, wobei die Grundeinheit (GE) vom zumindest einen Akkumulatormodul (A1, A2, A3) räumlich getrennt angeordnet sein kann, ***dadurch gekennzeichnet, dass*** regelmäßig von der Überwachungseinheit (UE1, UE2, UE3) des zumindest einen Akkumulatormoduls (A1, A2, A3) ein jeweils aktueller, ladespezifischer Zustand des zumindest einen Akkumulatormodul (A1, A2, A3) ermittelt wird, dass der jeweils aktuelle, ladespezifische Zustand des zumindest einen Akkumulatormoduls (A1, A2, A3) an die Grundeinheit (GE) übertragen wird, und dass der jeweils aktuell übertragene, ladespezifische Zustand von der Steuereinheit (SE) der Grundeinheit (SE) ausgewertet und die Ladeeinheit (LE) der Grundeinheit (GE) entsprechend angesteuert wird.

2. Verfahren nach Anspruch 1, ***dadurch gekennzeichnet, dass*** der jeweils aktuelle, ladespezifischen Zustand des zumindest einen Akkumulatormoduls (A1, A2, A3) von der Überwachungseinheit (UE1, UE2, UE3) anhand aktueller Messwerte von Betriebsparameter, insbesondere Temperatur und/oder Spannung des zumindest einen Akkumulatormoduls (A1, A2, A3), und anhand von vorgegebenen Akkumulatorparametern für das zumindest eine Akkumulatormodul (A1, A2, A3) ermittelt werden.

3. Verfahren nach einem der Ansprüche 1 bis 2, ***dadurch gekennzeichnet, dass*** die ladespezifischen Zustände des zumindest einen Akkumulatormoduls (A1, A2, A3) in Abhängigkeit von zumindest einen vorgegebenen Akkumulatorparameter für einen Ladevorgang und/oder Entladevorgang des zumindest einen Akkumulatormoduls (A1, A2, A3) definiert werden.

4. Verfahren nach einem der Ansprüche 1 bis 3, ***dadurch gekennzeichnet, dass*** weiterhin für die Grundeinheit (GE) Funktionszustände definiert werden, welche für ein Starten und/oder Beenden des Ladevorgangs und/oder Entladevorgang an das zumindest eine Akkumulatormodul (A1, A2, A3) übertragen werden.

5. Verfahren nach einem der Ansprüche 1 bis 4, ***dadurch gekennzeichnet, dass*** die aktuellen Messwerte der Betriebsparameter, insbesondere von Temperatur und/oder Spannung des zumindest einen Akkumulatormoduls (A1, A2, A3), für weitere Auswertungen und/oder optische Darstellungen an die Grundeinheit (GE) und/oder an eine übergeordnete Kontrolleinheit übertragen werden.

6. Verfahren nach einem der Ansprüche 1 bis 5, ***dadurch gekennzeichnet, dass*** die aktuellen, ladespezifischen Zustände des zumindest einen Akkumulatormoduls (A1, A2, A3) und die Funktionszustände der Grundeinheit (GE) über eine digitale Schnittstelle (DS) zwischen der Grundeinheit (GE) und dem zumindest einen Akkumulatormodul (A1, A2, A3) übertragen werden.

7. Verfahren nach einem der Ansprüche 1 bis 6, ***dadurch gekennzeichnet, dass*** weiterhin über die digitale Schnittstelle (DS) die aktuellen Messwerte der Betriebsparameter an die Grundeinheit (GE) übertragen werden.

8. Verfahren nach einem der Ansprüche 1 bis 6, ***dadurch gekennzeichnet, dass*** zusätzlich zur digitalen Schnittstelle (DS) eine analoge Schnittstelle implementiert wird, über welche die aktuellen Messwerte der Betriebsparameter an die Grundeinheit (GE) übertragen werden.

9. Unterbrechungsfreies Stromversorgungssystem zur Durchführung eines Verfahrens nach einem der Ansprüche 1 bis 8, zumindest bestehend aus:
- einer Grundeinheit (GE), welche zumindest eine Ladeeinheit (LE) sowie eine Steuereinheit (SE) zum Steuern der Ladeeinheit (LE) umfasst, und;
- zumindest einem Akkumulatormodul (A1, A2, A3), welches eine Überwachungseinheit (UE1, UE2, UE3) aufweist und räumlich getrennt von der Grundeinheit (GE) angebracht sein kann, ***dadurch gekennzeichnet, dass*** die Überwachungseinheit (UE1, UE2, UE3) dazu eingerichtet ist, regelmäßig einen jeweils aktuellen, ladespezifischen Zustand des zumindest einen Akkumulatormoduls (A1, A2, A3) zu ermitteln und an die Grundeinheit (GE) zu übertragen, und dass die Steuereinheit (SE) der Grundeinheit (GE) dazu eingerichtet ist, den jeweils aktuell übertragenen, ladespezifischen Zustand des zumindest einen Akkumulatormoduls (A1, A2, A3) auszuwerten und die Ladeeinheit (LE) entsprechend anzusteuern.

10. Unterbrechungsfreies Stromversorgungssystem nach Anspruch *9, **dadurch gekennzeichnet, dass*** die Überwachungseinheit (UE1, UE2, UE3) des zumindest einen Akkumulatormoduls (A1, A2, A3) dazu eingerichtet ist, aktuelle Werte von Betriebsparametern des zumindest einen Akkumulatormoduls (A1, A2, A3) zu messen, und aus den gemessenen aktuellen Werten der Betriebsparameter sowie anhand von vorgegebenen Akkumulatorparametern des zumindest einen Akkumulatormoduls (A1, A2, A3) den jeweils aktuellen, ladespezifischen Zustand abzuleiten.

11. Unterbrechungsfreies Stromversorgungssystem nach einem der Ansprüche 9 bis 10, ***dadurch gekennzeichnet, dass*** eine digitale Schnittstelle (DS) zum Übertragen der jeweils aktuellen, ladespezifischen Zustände des zumindest einen Akkumulatormoduls (A1, A2, A3) sowie von Funktionszustände, welche für die Grundeinheit definierbar sind, zum zumindest einen Akkumulatormodul (A1, A2, A3) vorgesehen ist.

12. Unterbrechungsfreies Stromversorgungssystem nach Anspruch 11, ***dadurch gekennzeichnet, dass*** die digitale Schnittstelle (DS) weiterhin für eine Übertragung von aktuellen Messwerten von Betriebsparameter des zumindest eine Akkumulatormoduls (A1, A2, A3) nutzbar ist.

13. Unterbrechungsfreies Stromversorgungssystem nach Anspruch 11, ***dadurch gekennzeichnet, dass*** zusätzlich zur digitalen Schnittstelle (DS) eine analoge Schnittstelle zum Übertragen von aktuellen Messwerte der Betriebsparameter des zumindest eine Akkumulatormoduls (A1, A2, A3) vorgesehen ist.
